# EUROPEAN PATENT SPECIFICATION

(11) **EP 1 662 019 B1**
(45) Date of publication and mention of the grant of the patent: **16.07.2008**
(21) Application number: 05255509.1
(22) Date of filing: 08.09.2005
(51) Int. Cl.: C23C 14/58, C22F 1/18

(54) **Method of producing defect free deposited titanium alloys**
Verfahren zur Herstellung von defektfreien beschichteten Titanlegierungen
Procédé de fabrication des revêtements à base de titan sans défaut

(30) Priority: 17.11.2004 US 991604
(43) Date of publication of application: 31.05.2006
(73) Proprietor: United Technologies Corporation, Hartford, Connecticut 06101 (US)
(72) Inventor: Kinstler, Monika D., Glastonbury, CT 06033 (US); Ivasishin, Orest M., 03179 Kiev (UA); Serhiyenko, Gregory A., 01042 Kiev (UA); Markovsky, Pavel E., 03142 Kiev (UA); Bondarchuk, Vadim I., 03164 Kiev (UA); Belousov, Igor V., Kiev (UA)
(74) Representative: Hall, Matthew Benjamin

(56) References cited:
- US-A- 5 474 809
- IVASISHIN O M ET AL: "ENHANCING THE MECHANICAL PROPERTIES OF TITANIUM ALLOYS WITH RAPID HEAT TREATMENT" JOM, MINERALS METALS & MATERIALS SOCIETY, WARRENDALE, PA, US, vol. 48, no. 7, 1 July 1996 (1996-07-01), pages 48-52, XP000597347 ISSN: 1047-4838

## Description

The invention relates to deposition of Ti-based materials. More particularly, the invention relates to addressing deposition defects.

A growing art exists regarding the deposition of Ti-based materials. For example, electron beam physical vapor deposition (EBPVD) may be used to build a coating or structural condensate of a Ti alloy atop a substrate of like or dissimilar nominal composition. Such techniques may be used in the aerospace industry for the repair or remanufacture of damaged or worn parts such as gas turbine engine components (e.g., blades, vanes, seals, and the like).

Deposition defects, however, potentially compromise the condensate integrity. One group of such defects arises when a droplet of material is spattered onto the substrate or the accumulating condensate. The melt pool may contain additives not intended to vaporize and accumulate in the condensate. For example, U.S. Patent No. 5,474,809 discloses use of refractory elements in the melt pool. Once the droplet lands on the surface (of the substrate or the accumulating condensate) further deposition builds atop the droplet and the adjacent surface. Along the sides of the droplet, there may be microstructural discontinuities in the accumulating material due to the relative orientation of the sides of the droplet. As further material accumulates, these discontinuities may continue to build all the way to the final condensate surface.

"Enhancing the Mechanical Properties of Titanium Alloys with Rapid Heat Treatment" by O.M. Ivasishin and P.E. Markovsky, JOM, Minerals & Materials Society, Warrendale PA, US, Vol. 48 No. 7, 1 July 1996, pages 48-52 discloses heat treatment of titanium alloys by rapid heating into the β-field

One aspect of the invention provides a method for treating a deposited titanium-base material from an initial condition to a treated condition as set out in claim 1. The material is heated from a first temperature to a second temperature. The first temperature is below an equilibrium β transus. The second temperature is above the equilibrium β transus. The heating includes a portion at a rate in excess of 5°C/s. The material is cooled from the second temperature to a third temperature below the equilibrium β transus.

In various implementations, the heating may be to a peak at least 10°C above a non-equilibrium β transus. The material may be above the equilibrium β transus for a brief period (e.g., no more than 2.0 seconds). The heating and cooling may have sufficient rates to maintain a characteristic grain size of at least a matrix of the material below 100µm.

In one group of implementations, the heating may be to a peak 10-50°C above a non-equilibrium β transus. The material may be above the equilibrium β transus for a very brief period (e.g., no more than 1.0 seconds). In another group of potentially overlapping implementations, the heating may be to 1-30°C above the equilibrium β transus for a somewhat longer period (e.g., 1.0-5.0 seconds). The cooling may be sufficiently rapid to limit β growth to a characteristic size smaller than 100µm. One group of materials consist in largest weight parts of titanium, aluminum, and vanadium. An exemplary material thickness may be at least 2.0mm (e.g., for relatively thick structural and repair material, contrasted with thinner coatings).

Other features, objects, and advantages of the invention will be apparent from the description and drawings, and from the claims.

One or more preferred embodiments of the present invention will now be described by way of example only and with reference to the accompanying drawings in which:
FIG. 1 is an optical micrograph of a Ti-6Al-4V condensate atop a like substrate and showing defects.
FIG. 2 is a view of a healed condensate.
FIG. 3 is a temperature-time diagram showing healing processes.

Like reference numbers and designations in the various drawings indicate like elements.

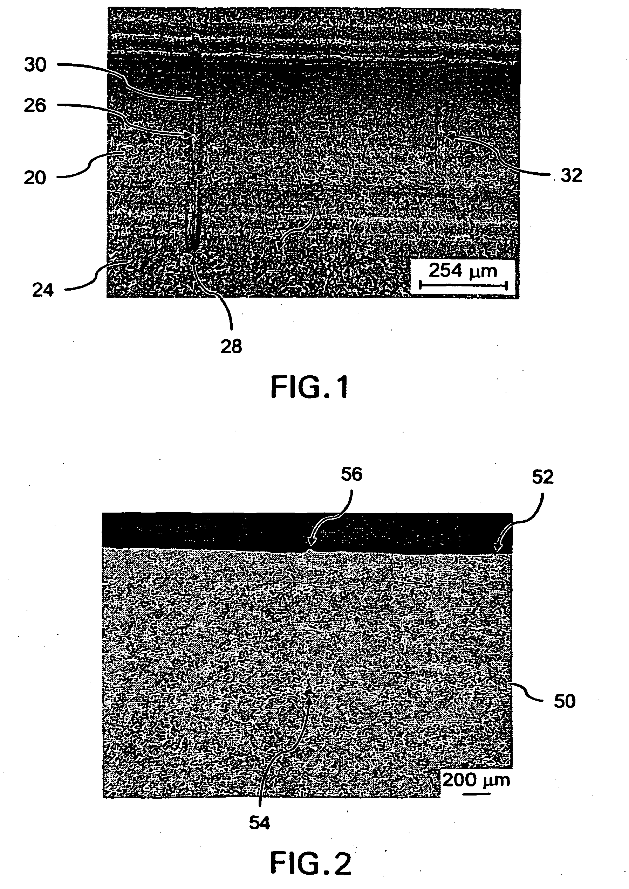

FIG. 1 shows a condensate 20 accumulated atop a surface 22 of a substrate 24. Exemplary condensate thickness may be from less than 0.2mm (e.g., for thin coatings) to in excess of 2mm (at least locally - e.g., for structural condensates such as certain repairs). The condensate has a first defect 26 triggered by a spattered molybdenum droplet 28 that landed atop the surface 22. Exemplary droplet sizes are 30-500µm (measured as a characteristic (mean/median/mode) transverse dimension). The defect comprises a trunk 30 extending from the droplet 28 toward the condensate surface (not shown). A second defect 32 is shown and may have been triggered by a droplet below the cut surface of the view.

The exemplary deposition is of nominal Ti-6Al-4V condensate atop a like substrate. Alternate depositions may include Ti-6Al-2Sn-4Zr-2Mo and Ti-8Al-1Mo-1V. The deposition may be from a melted ingot at least partially through a pool containing one or more refractory or other elements which may be essentially non-consumed during deposition (e.g., a pool formed from a 30%Mo-70%Zr mixture). Accordingly, the droplets may tend to have composition similar to the surface layers of the pool. In the absence of the non-consumed pool additive, the droplet 28 might have a similar composition to the ingot yet still produce similar defects. Many droplets in systems using an Mo-containing pool would have Mo concentrations of at least 10% by weight; others at least 20%. This may be somewhat less than the Mo percentage of the non-expending pool material to reflect possible dilution by deposition material elements in the pool.

In the exemplary implementation, the substrate 28 has an α -β microstructure of medium to coarse grains (e.g., 10-40µm characteristic grain size (e.g., mean) or about ASTM 10.5-6.5). An exemplary 10-20% by weight of the substrate is β phase with the remainder essentially α phase. The condensate matrix (away from the defects) also has an α-β microstructure but of very fine grains (e.g., acicular α grains of 5-10µm in length and 2-5µm in thickness, lengthwise oriented along the condensate growth/deposition direction). The trunk size will depend, in substantial part, upon the droplet size. Exemplary trunk diameters are from about 20µm to about 50µm. However, much larger trunks are possible. The trunks have a columnar α -β microstructure. This microstructure may have a characteristic grain size several times greater than that in the matrix and the grains may be elongated in the direction of accumulation (i.e., away from the substrate). Particularly in the case of very large diameter trunks (e.g., in excess of 100µm in diameter), there may be porosity around the trunk. The grain discontinuity at the trunk-matrix interface and the particular alignment of trunk grains may cause structural weaknesses affecting, *inter alia,* ductility, fracture toughness, fatigue resistance, fretting fatigue resistance, corrosion resistance, wear resistance, crack nucleation resistance, and the like.

We have, accordingly, developed heat treatment regimes for healing workpieces having such defects. FIG. 2 shows a condensate 50 after healing. In this view, the substrate is not shown. The condensate surface 52 is, however, shown. A defect within the condensate had been caused by a droplet 54. The resultant trunk had propagated all the way to the surface forming a bulge 56. The healed condensate, however, shows essentially no remaining artifacts of the defect other than the original droplet 54 and bulge 56. The trunk has been microstructurally integrated with the condensate matrix as a fine β equiaxed microstructure (e.g., grain size of 10-100µm (~ASTM 10.5-3.5)). Additionally, laminar variations in chemistry or microstructure may be diminished or eliminated, thereby increasing the isotropy of the condensate mechanical properties. The bulge 56 may be removed (e.g., during a subsequent surface machining). The healing permits the workpiece (e.g., a blade, vane, seal, or the like) to be operated at ambient temperature (e.g., 0-40°C) and/or at elevated temperatures (e.g., above 250°C, such as in the range of 300-500°C) essentially without increased chances of failure.

### Example 1

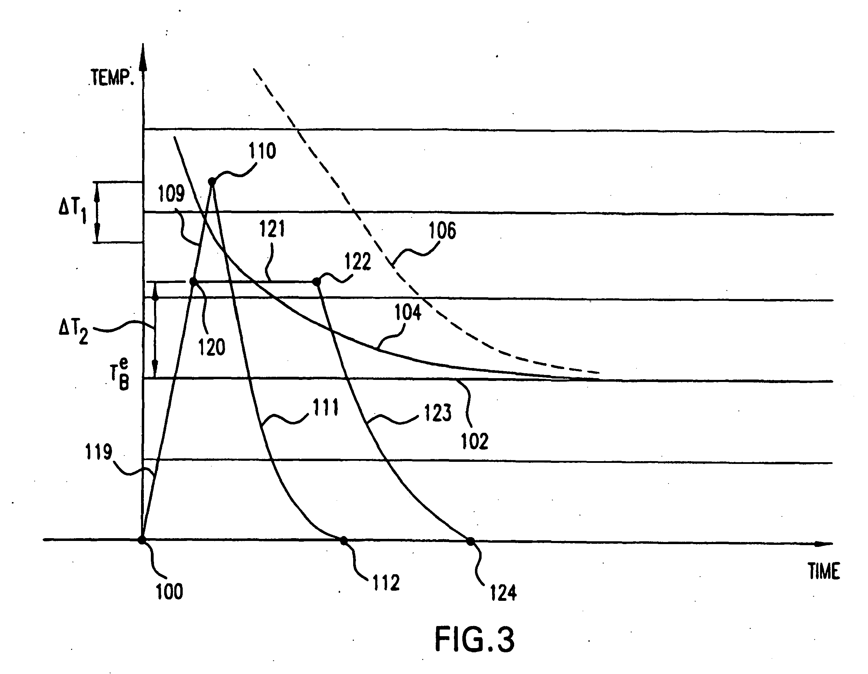

In a first exemplary healing method, the workpiece is initially at room temperature (condition/location 100) on the temperature against time plot of FIG. 3. FIG. 3 further shows a line 102 representing the equilibrium β transus (T^{e}_{β}) as well as curves 104 and 106 of non-equilibrium β transus temperatures for the condensate and substrate, respectively (specific to the microstructural and thermal history of this Example 1).The equilibrium β transus temperature is a function of chemistry only. Because the exemplary condensate and substrate have the same chemistry, they share the same equilibrium β transus temperature (e.g., 960-1010°C for Ti-6Al-4V). The non-equilibrium β transus temperature is a function of composition, grain size/morphology, and heating rate. The smaller the grains, the lower the transus temperature. The more rapid the heating rate, the higher the transus temperature. At very slow heating rates, the equilibrium transus temperature equals the non-equilibrium transus temperature. Given very fine condensate grains, medium to coarse substrate grains, and a heating rate of approximately 100°C/sec, it is estimated that the difference between the non-equilibrium β transus of the two structures is about 100°C.

In a first stage, the workpiece is heated 109 moderately above the condensate non-equilibrium β transus (condition/location 110). This heating may be under vacuum or in an inert atmosphere. This heating is advantageously rapid (e.g., occurring at a rate of 5-100°C/s or greater) so as to prevent excessive grain growth. Excessive grain growth (e.g., above 150µm (~ASTM 2.5) or even 100µm (~ASTM 3.5), depending upon the application) is disadvantageous because it excessively reduces structural properties including one or more of ductility, fracture toughness, fatigue resistance, fretting fatigue resistance, corrosion resistance, wear resistance, crack nucleation resistance, and the like. The heating reaches a peak of ΔT₁ above the condensate non-equilibrium β transus of approximately 10-50°C. The heating substantially converts the condensate microstructure to β. The upper limit on ΔT₁ will reflect the microstructural/thermal history and is advantageously sufficiently low to avoid excessive β grain growth (in view of time considerations discussed below). The lower limit is advantageously high enough to provide essentially complete transition to the β phase (α+β to β). The substrate may be essentially unaffected.

In a second stage, the workpiece is rapidly cooled 111 back to room temperature (condition/location 112). This heating may be under the same vacuum or atmosphere as the first stage. During this cooling, metastable martensite may accumulate in the condensate and the substrate. The cooling is advantageously sufficiently rapid to further limit β grain growth. The rapid heating and cooling maintain the condensate above its equilibrium β transus for a time interval sufficiently brief to avoid the excessive β grain growth noted above while providing the β phase transition. An exemplary time interval above the equilibrium β transus is 1.0 seconds or less. Once below the β transus, the β will transform to α+β in a β-transformed (also known as transformed β) microstructure. This microstructure is characterized by preservation of the boundaries of the prior β grains with α (e.g., in needle- or platelet-like form) in a β matrix within such boundaries. The rapid heating and cooling may provide a sufficiently short time at elevated temperature (in view of the magnitude of such temperature) to greatly limit oxidation even if the procedure is performed in an ambient atmosphere rather than under vacuum or an inert atmosphere. Thus, especially for workpieces to be exposed to relatively low thermal and mechanical stresses (e.g., some non-rotating turbine engine parts), there may be greater environmental flexibility during the heating and/or cooling.

An optional third stage (not shown in FIG. 3) involves annealing/aging by heating the workpiece to an annealing temperature (e.g., in the vicinity of 500-600°C for the exemplary Ti alloy). The exemplary annealing/aging is for a period of 1-24 hours and is effective to eliminate the martensite but without producing β grain growth. This may leave the condensate as essentially fine grain β (e.g., broadly smaller than 150µm, more narrowly smaller than 100µm, and preferably smaller than 50µm (~ASTM 2.5, 3.5, and 5.5, respectively)) plus the droplets and leaves the substrate as essentially medium to coarse grain α-β. However, the cooling of the second stage may be sufficiently slow to avoid martensite formation, in which case it is particularly appropriate to omit the aging/annealing.

### Example 2

In a second exemplary healing method, the initial heating stage 119 is similarly rapid but to a temperature above the equilibrium β transus but below the condensate non-equilibrium β transus. The resulting condition/location 120 may be at a temperature of ΔT₂ above the equilibrium β transus (e.g., by 10-30°C). The upper limit on this range is advantageously effective to avoid excessive β grain growth. The lower limit on this range is advantageously high enough to provide essentially complete transition to the β phase (α+β to β). The substrate may be essentially unaffected.

Rather than being immediately followed by rapid cooling, the workpiece is maintained 121 at such a temperature for a moderate time interval (e.g., of about two seconds, more broadly 1.5-4.0 seconds or 1.0-5.0 seconds) to achieve a condition/location 122. It is during this time interval that the condensate microstructure changes to fine β as in condition/location 110. Thereafter, a rapid cooling 123 may transition the workpiece to a condition/location 124 similar to 112 and may, in turn, be followed by a similar annealing/aging if appropriate or desired.

The heating and cooling may be performed by a variety of techniques. One family of rapid heating techniques provides highly local heating (exemplary such techniques include induction heating, laser heating, electron beam heating, and the like). Such heating facilitates heating of the condensate with less substantial heating of the substrate, thereby minimizing any structural effects on the substrate. The desired heating depth may be controlled in view of the coating thickness by means including frequency control of induction heating, beam intensity of laser or electron beam heating, and the like. With some implementations of such heating, the heating may progress across the condensate (e.g., by moving or reorienting the workpiece relative to the heating source). Direct electrical resistance heating may be used to more generally heat the workpiece. The exemplary rapid cooling may be performed by forced cooling with an inert gas (especially when the heating is performed under vacuum), forced air cooling, liquid quench (e.g., in oil or water), and the like.

One or more embodiments of the present invention have been described. Nevertheless, it will be understood that various modifications may be made without departing from the scope of the invention. For example, details of the chemical composition of the particular substrate and condensate and of the physical configuration of the substrate and thickness of the condensate may influence details of any particular implementation. Accordingly, other embodiments are within the scope of the following claims.

## Claims

1. A method for treating a deposited titanium-base material from an initial condition including a plurality of defects having trunks with a microstructure distinct from a microstructure of a matrix of the material to a treated condition where the trunks' microstructure have been essentially integrated with the matrix microstructure. comprising:
heating from a first temperature to a second temperature, the first temperature being below an equilibrium β transus, the second temperature being above the equilibrium β transus, and the heating including a portion at a rate in excess of 5°C/s; and
cooling from the second temperature to a third temperature below the equilibrium β transus.

2. The method of claim 1 wherein:
the heating is to a peak at least 10°C above a non-equilibrium β transus; and
the material is above the equilibrium β transus for a period of no more than 2.0 seconds.

3. The method of claim 1 or 2 wherein:
the heating and cooling have.sufficient rates to maintain a characteristic grain size of at least a matrix of the material smaller than 100µm.

4. The method of any preceding claim wherein:
the heating is to a peak 10-50°C above a non-equilibrium β transus; and
the material is above the equilibrium β transus for a period of no more than 1.0 seconds.

5. The method of any preceding claim wherein:
the heating is 1-30°C above the equilibrium β transus for a period of 1.0-5.0 seconds; and
the cooling is sufficiently rapid to limit β growth to a characteristic size smaller than 100µm.

6. The method of any preceding claim wherein:
the material consists in largest weight parts of titanium, aluminum, and vanadium; and
the material has a maximum thickness of at least 2.0mm.

7. The method of any preceding claim wherein:
the material is on a titanium-base substrate; and
the heating leaves essentially unaffected a microstructure of a major portion of the substrate.

8. The method of any preceding claim wherein:
the heating is selected from the group consisting of direct resistance heating, induction heating, electron beam heating, and combinations thereof.

9. The method of any preceding claim further comprising:
depositing the material on a titanium-base substrate.

10. The method of claim 9 wherein:
the depositing comprises electron beam physical vapor deposition.

11. The method of claim 9 or 10 wherein:
the material and the substrate consist essentially of an alloy of 5-7 weight percent aluminum, 3-5 weight percent vanadium, balance titanium, with less than 3 weight percent other components.

12. The method of any preceding claim further comprising:
an annealing and aging step.

13. The method of claim 12 further comprising:
maintaining the material at a temperature of 500-660°C.

14. The method of any preceding claim used to repair a gas turbine engine component having a titanium-base substrate.

15. The method of claim 14 further comprising:
operating the repaired component at a temperature in excess of 250°C.

16. The method of any preceding claim wherein in the treated condition a laminar variation in at least a first alloy component is less than in the initial condition.

17. The method of claim 1, wherein in the initial condition the matrix has a first nominal chemistry and a first characteristic grain size and first characteristic grain structure, and the trunk has essentially the same chemistry as the matrix, but a larger second characteristic grain size and less equiaxed second grain structure.

18. The method of claim 17, wherein in the initial condition the material has a plurality of spits within the matrix and having:
a droplet having a higher level of refractory impurities than the matrix; and
the trunks extend from the droplets.

19. The method of claim 17 or 18, wherein the heating and cooling is sufficiently rapid to convert an α-β microstructure of the material to an essentially β-transformed microstructure, optionally including metastable martensite, and having a characteristic grain size smaller than 100µm.

20. The method of claim 17, 18, or 19, wherein:
the first nominal chemistry is essentially Ti-6Al-4V;
the second nominal chemistry is essentially Ti-6Al-4V; and
the material is atop an essentially Ti-6Al-4V substrate.

21. The method of claim 18, wherein:
at least some of the spits are further **characterized by** porosity adjacent their trunks; and
at least some of the porosity is healed.

22. The method of claim 18, wherein:
the droplets comprise at least 10% of one or a combination of refractory metals, by weight.

23. The method of any of claims 17 to 22 further comprising:
an annealing/aging step effective to essentially eliminate the martensite.

24. The method of any of claims 17 to 23 wherein:
the material is a repair material on a turbine engine component.

25. A component treated by the method of any preceding claim, the component having:
a Ti-based metallic substrate; and
a Ti-based condensate atop the substrate and having:
a surface;
a plurality of embedded droplets below the surface;
regions directly between the droplets and the surface **characterized by**
an essentially β-transformed microstructure of a characteristic grain size below 100µm.

26. The component of claim 25 wherein:
at least some of said droplets are at least 200µm below the surface.

27. The component of claim 25 or 26 wherein:
at least some of said droplets are at least 20µm in characteristic transverse dimension.

28. The component of claim 25, 26 or 27 wherein:
at least some of said droplets comprise at least 20% Mo, by weight.

29. The component of any of claims 25 to 28 wherein:
the substrate and the condensate each consist essentially of Ti-6A1-4V.

30. The component of any of claims 25 to 29 being one of a gas turbine engine compressor blade, fan blade, disk, drum rotor, bearing housing, vane, and seal element.

## Patentansprüche

1. Verfahren zur Behandlung eines abgeschiedenen Materials auf Titan-Basis von einem Ausgangszustand, der eine Mehrzahl von Fehlern mit Körpern mit einer Mikrostruktur, die sich von einer Mikrostruktur einer Matrix des Materials unterscheidet, zu einem behandelten Zustand, in dem die Mikrostruktur der Körper im Wesentlichen in die Mikrostruktur der Matrix integriert wurde, aufweisend:
Erhitzen von einer ersten Temperatur auf eine zweite Temperatur, wobei die erste Temperatur unter einem Gleichgewichts-β-Übergang ist, die zweite Temperatur über dem Gleichgewichts-β-Übergang ist, und das Erhitzen einen Abschnitt mit einer Geschwindigkeit über 5°C/s umfasst; und
Abkühlen von der zweiten Temperatur auf eine dritte Temperatur unter dem Gleichgewichts-β-Übergang.

2. Verfahren nach Anspruch 1, bei dem:
das Erhitzen auf ein Maximum mindestens 10°C über einem Nicht-Gleichgewichts-β-Übergang erfolgt; und
das Material sich für eine Dauer von nicht mehr als 2,0 s über dem Gleichgewichts-β-Übergang befindet.

3. Verfahren nach Anspruch 1 oder 2, bei dem:
das Erhitzen und das Abkühlen ausreichende Geschwindigkeiten haben, um eine charakteristische Korngröße mindestens einer Matrix des Materials von kleiner als 100 µm beizubehalten.

4. Verfahren nach irgendeinem vorangehenden Anspruch, bei dem:
das Erhitzen auf ein Maximum 10 bis 50°C über einem Nicht-Gleichgewichtsp-Übergang erfolgt; und
das Material sich für eine Dauer von nicht mehr als 1,0 s über dem Gleichgewichts-β-Übergang befindet.

5. Verfahren nach irgendeinem vorangehenden Anspruch, bei dem:
das Erhitzen für eine Dauer von 1,0 bis 5,0 s 1 bis 30°C über dem Gleichgewichts-β-Übergang erfolgt; und
das Abkühlen ausreichend schnell ist, um das β-Wachstum auf eine charakteristische Größe von kleiner als 100 µm zu begrenzen.

6. Verfahren nach irgendeinem vorangehenden Anspruch, bei dem:
das Material zu den größten Gewichtsteilen aus Titan, Aluminium und Vanadium besteht; und
das Material eine maximale Dicke von mindestens 2,0 mm hat.

7. Verfahren nach irgendeinem vorangehenden Anspruch, bei dem:
das Material sich auf einem Substrat auf Titan-Basis befindet; und
das Erhitzen eine Mikrostruktur eines Hauptteils des Substrats im Wesentlichen unbeeinflusst lässt.

8. Verfahren nach irgendeinem vorangehenden Anspruch, bei dem:
das Erhitzen ausgewählt wird aus der Gruppe, die aus direktem Widerstandserhitzen, Induktionserhitzen, Elektronenstrahl-Erhitzen und Kombinationen davon besteht.

9. Verfahren nach irgendeinem vorangehenden Anspruch, außerdem aufweisend:
Abscheiden des Materials auf einem Substrat auf Titan-Basis.

10. Verfahren nach Anspruch 9, bei dem:
das Abscheiden eine physikalische Elektronenstrahl-Dampfabscheidung aufweist.

11. Verfahren nach Anspruch 9 oder 10, bei dem:
das Material und das Substrat im Wesentlichen aus einer Legierung aus 5 bis 7 Gew.-% Aluminium, 3 bis 5 Gew.-% Vanadium, Rest Titan, mit weniger als 3 Gew.-% anderen Komponenten, bestehen.

12. Verfahren nach irgendeinem vorangehenden Anspruch, außerdem aufweisend:
einen Temper- und Alterungsschritt.

13. Verfahren nach Anspruch 12, außerdem aufweisend:
Halten des Materials bei einer Temperatur von 500 bis 660°C.

14. Verfahren nach irgendeinem vorangehenden Anspruch, das zum Reparieren eines Gasturbinenmaschinen-Bauteils mit einem Substrat auf Titan-Basis verwendet wird.

15. Verfahren nach Anspruch 14, außerdem aufweisend:
Betreiben des reparierten Bauteils bei einer Temperatur über 250°C.

16. Verfahren nach irgendeinem vorangehenden Anspruch, bei dem in dem behandelten Zustand eine laminare Abweichung in mindestens einer ersten Legierungskomponente geringer ist als in dem Ausgangszustand.

17. Verfahren nach Anspruch 1, bei dem in dem Ausgangszustand die Matrix eine erste nominelle Chemie und eine erste charakteristische Korngröße und eine erste charakteristische Kornstruktur hat, und der Körper im Wesentlichen dieselbe Chemie wie die Matrix, aber eine größere zweite charakteristische Korngröße und eine weniger äquiaxiale zweite Kornstruktur hat.

18. Verfahren nach Anspruch 17, bei dem in dem Ausgangszustand das Material eine Mehrzahl von Spritzern in der Matrix hat und mit:
einem Tröpfchen mit einem höheren Gehalt an hochschmelzenden Verunreinigungen als die Matrix; und
wobei sich die Körper von den Tröpfchen erstrecken.

19. Verfahren nach Anspruch 17 oder 18, bei dem das Erhitzen und Abkühlen ausreichend schnell ist, um eine α-β-Mikrostruktur des Materials in eine im Wesentlichen β-transformierte Mikrostruktur umzuwandeln, die optional metastabilen Martensit enthält und die eine charakteristische Korngröße von kleiner als 100 µm hat.

20. Verfahren nach Anspruch 17, 18 oder 19, bei dem:
die erste nominelle Chemie im Wesentlichen Ti-6AI-4V ist;
die zweite nominelle Chemie im Wesentlichen Ti-6AI-4V ist; und
das Material sich oben auf einem Substrat aus im Wesentlichen Ti-6Al-4V befindet.

21. Verfahren nach Anspruch 18, bei dem:
mindestens einige der Spritzer außerdem durch eine ihren Körpern benachbarte Porosität **gekennzeichnet** sind; und
mindestens etwas von der Porosität ausgeheilt wird.

22. Verfahren nach Anspruch 18, bei dem:
die Tröpfchen mindestens 10 Gew.-% eines schwerschmelzenden Metalls oder einer Kombination schwerschmelzender Metalle aufweisen.

23. Verfahren nach irgendeinem der Ansprüche 17 bis 22, außerdem aufweisend:
einen Temper-/Alterungsschritt, der wirksam ist, den Martensit im Wesentlichen zu beseitigen.

24. Verfahren nach irgendeinem der Ansprüche 17 bis 23, bei dem:
das Material ein Reparaturmaterial auf einem Turbinenmaschinen-Bauteil ist.

25. Bauteil, das nach dem Verfahren irgendeines vorangehenden Anspruchs behandelt wurde, wobei das Bauteil hat:
ein metallisches Substrat auf Ti-Basis; und
ein Kondensat auf Ti-Basis oben auf dem Substrat und mit:
einer Oberfläche;
einer Mehrzahl eingebetteter Tröpfchen unter der Oberfläche;
Bereichen unmittelbar zwischen den Tröpfchen und der Oberfläche,
**gekennzeichnet durch**
eine im Wesentlichen β-transformierte Mikrostruktur einer charakteristischen Korngröße unter 100 µm.

26. Bauteil nach Anspruch 25, bei dem:
mindestens einige der Tröpfchen mindestens 200 µm unter der Oberfläche sind.

27. Bauteil nach Anspruch 25 oder 26, bei dem:
mindestens einige der Tröpfchen mindestens 20 µm in der charakteristischen Querabmessung haben.

28. Bauteil nach Anspruch 25, 26 oder 27, bei dem:
mindestens einige der Tröpfchen mindestens 20 Gew.-% Mo aufweisen.

29. Bauteil nach irgendeinem der Ansprüche 25 bis 28, bei dem:
das Substrat und das Kondensat jeweils im Wesentlichen aus Ti-6Al-4V bestehen.

30. Bauteil nach irgendeinem der Ansprüche 25 bis 29, das eines der Bauteile Gasturbinenmaschinen-Kompressorlaufschaufel, Gebläseschaufel bzw. Bläserschaufel, Scheibe, Trommelrotor, Lagergehäuse, Leitschaufel und Dichtungselement ist.

## Revendications

1. Procédé de traitement d'un matériau déposé à base de titane d'un état initial comportant une pluralité de défauts ayant des corps avec une microstructure distincte d'une microstructure d'une matrice du matériau jusqu'à un état traité où la microstructure des corps a été fondamentalement intégrée à la microstructure de matrice, comprenant les étapes consistant à :
chauffer, d'une première température jusqu'à une deuxième température, la première température étant au-dessous d'un transus β d'équilibre, la deuxième température étant au-dessus du transus β d'équilibre, et le chauffage comportant une portion à une vitesse dépassant 5 °C/s ; et
refroidir de la deuxième température jusqu'à une troisième température au-dessous du transus β d'équilibre.

2. Procédé selon la revendication 1, dans lequel :
le chauffage s'effectue jusqu'à une température maximale d'au moins 10 °C au-dessus d'un transus β de non-équilibre ; et
le matériau se trouve au-dessus du transus β d'équilibre pendant une période n'excédant pas 2,0 secondes.

3. Procédé selon la revendication 1 ou 2, dans lequel :
le chauffage et le refroidissement ont des vitesses suffisantes pour maintenir une grosseur de grain caractéristique d'au moins une matrice du matériau inférieure à 100 µm.

4. Procédé selon l'une quelconque des revendications précédentes, dans lequel :
le chauffage s'effectue jusqu'à une température maximale de 10 à 50 °C au-dessus d'un transus β de non-équilibre ; et
le matériau se trouve au-dessus du transus β d'équilibre pendant une période n'excédant pas 1,0 seconde.

5. Procédé selon l'une quelconque des revendications précédentes, dans lequel :
le chauffage est de 1 à 30 °C au-dessus du transus β d'équilibre pendant une période de 1,0 à 5,0 secondes ; et
le refroidissement est suffisamment rapide pour limiter la croissance β à une taille caractéristique inférieure à 100 µm.

6. Procédé selon l'une quelconque des revendications précédentes, dans lequel :
le matériau se compose, des plus grandes parties en poids, de titane, d'aluminium et de vanadium ; et
le matériau a une épaisseur maximale d'au moins 2,0 mm.

7. Procédé selon l'une quelconque des revendications précédentes, dans les :
le matériau est sur un substrat à base de titane ; et
le chauffage n'affecte pas fondamentalement une microstructure d'une portion importante du substrat.

8. Procédé selon l'une quelconque des revendications précédentes, dans lequel :
le chauffage est sélectionné dans le groupe se composant d'un chauffage direct par résistance, d'un chauffage par induction, d'un chauffage par bombardement électronique, et de combinaisons de ceux-ci.

9. Procédé selon l'une quelconque des revendications précédentes, comprenant en outre l'étape consistant à :
déposer le matériau sur un substrat à base de titane.

10. Procédé selon la revendication 9, dans lequel :
le dépôt comprend un dépôt physique en phase vapeur par bombardement électronique.

11. Procédé selon la revendication 9 ou 10, dans lequel :
le matériau et le substrat se composent fondamentalement d'un alliage de 5 à 7 pour cent en poids d'aluminium, 3 à 5 pour cent en poids de vanadium, de titane pour la différence, avec moins de 3 pour cent en poids d'autres composants.

12. Procédé selon l'une quelconque des revendications précédentes, comprenant en outre :
une étape de recuit et de vieillissement.

13. Procédé selon la revendication 12, comprenant en outre l'étape consistant à :
maintenir le matériau à une température de 500 à 660 °C.

14. Procédé selon l'une quelconque des revendications précédentes, utilisé pour réparer un composant de moteur à turbine à gaz ayant un substrat à base de titane.

15. Procédé selon la revendication 14, comprenant en outre l'étape consistant à :
faire fonctionner le composant réparé à une température dépassant 250 °C.

16. Procédé selon l'une quelconque des revendications précédentes, dans lequel, dans l'état traité, une variation laminaire d'au moins un premier composant d'alliage est moindre que dans l'état initial.

17. Procédé selon la revendication 1, dans lequel, dans l'état initial, la matrice a une première composition chimique nominale et une première grosseur de grain caractéristique et une première structure de grain caractéristique, et le corps a fondamentalement la même composition chimique que la matrice, mais une seconde grosseur de grain caractéristique plus grande et une seconde structure de grain moins équiaxiale.

18. Procédé selon la revendication 17, dans lequel, dans l'état initial, le matériau a une pluralité de pointes à l'intérieur de la matrice et ayant :
une gouttelette ayant un niveau plus élevé d'impuretés réfractaires que la matrice ; et
les corps s'étendent depuis les gouttelettes.

19. Procédé selon la revendication 17 ou 18, dans lequel le chauffage et le refroidissement sont suffisamment rapides pour convertir une microstructure α-β du matériau en une microstructure fondamentalement β-transformée, comportant éventuellement une martensite métastable, et ayant une grosseur de grain caractéristique inférieure à 100 µm.

20. Procédé selon les revendications 17, 18 ou 19, dans lequel :
la première composition chimique nominale est fondamentalement Ti-6Al-4V ;
la seconde composition chimique nominale est fondamentalement Ti-6Al-4V ; et
le matériau est en haut d'un substrat fondamentalement en Ti-6Al-4V.

21. Procédé selon la revendication 18 dans lequel :
au moins une partie des pointes sont en outre **caractérisées par** une porosité adjacente à leurs corps ; et
au moins une partie de la porosité est endiguée.

22. Procédé selon la revendication 18 dans lequel :
les gouttelettes comprennent au moins 10 % d'un ou une combinaison de métaux réfractaires, en poids.

23. Procédé selon l'une quelconque des revendications 17 à 22, comprenant en outre :
une étape de recuit/vieillissement efficace pour éliminer fondamentalement la martensite.

24. Procédé selon l'une quelconque des revendications 17 à 23 dans lequel :
le matériau est un matériau de réparation sur un composant de moteur à turbine.

25. Composant traité par le procédé selon l'une quelconque des revendications précédentes, le composant ayant :
un substrat métallique à base de Ti ; et
un condensat à base de Ti en haut du substrat et ayant :
une surface ;
une pluralité de gouttelettes incorporées au-dessous de la surface ;
des régions directement entre les gouttelettes et la surface
**caractérisées par**
une microstructure fondamentalement β-transformée d'une grosseur de grain caractéristique au-dessous de 100 µm.

26. Composant selon la revendication 25 dans lequel :
au moins une partie desdites gouttelettes est au moins à 200 µm au-dessous de la surface.

27. Composant selon la revendication 25 ou 26 dans lequel :
au moins une partie desdites gouttelettes est au moins d'une dimension transversale caractéristique de 20 µm.

28. Composant selon les revendications 25, 26 ou 27 dans lequel :
au moins une partie desdites gouttelettes comprend au moins 20 % de Mo, en poids.

29. Composant selon l'une quelconque des revendications 25 à 28 dans lequel :
le substrat et le condensat se composent chacun, fondamentalement de Ti-6Al-4V.

30. Composant selon l'une quelconque des revendications 25 à 29, étant un composant de l'un parmi une aube de compresseur de moteur à turbine à gaz, une aube de soufflante, un disque, un rotor à tambour, un logement de palier, une pale et un élément d'étanchéité.
